(19) **Europäisches Patentamt**
**European Patent Office**
**Office européen des brevets**

(11) **EP 0 931 379 B1**

(12) **EUROPEAN PATENT SPECIFICATION**

(45) Date of publication and mention
of the grant of the patent:
**06.08.2008 Bulletin 2008/32**

(51) Int Cl.:
*H03K 17/56* (2006.01)    *H03K 17/687* (2006.01)
*H03K 17/74* (2006.01)    *H01L 29/788* (2006.01)
*H02M 3/07* (2006.01)

(21) Application number: **96939448.5**

(22) Date of filing: **10.10.1996**

(86) International application number:
**PCT/US1996/016317**

(87) International publication number:
**WO 1998/016010 (16.04.1998 Gazette 1998/15)**

(54) **TRIPLE WELL CHARGE PUMP**

DREIFACHWANNEN-LADUNGSPUMPE

POMPE A CHARGE AVEC TROIS PUITS

(84) Designated Contracting States:
**DE FR GB IT**

(43) Date of publication of application:
**28.07.1999 Bulletin 1999/30**

(73) Proprietor: **MACRONIX INTERNATIONAL CO., LTD.**
**Hsinchu (TW)**

(72) Inventors:
• **HUNG, Chun-Hsiung**
**Hsinchu (TW)**

• **WAN, Ray-Lin**
**Fremont, CA 94539 (US)**
• **CHENG, Yao-Wu**
**Taipei (TW)**

(74) Representative: **Horner, David Richard**
**D Young & Co**
**120 Holborn**
**London EC1N 2DY (GB)**

(56) References cited:
**EP-A- 0 319 063          EP-A- 0 678 970**
**US-A- 5 394 365          US-A- 5 489 870**
**US-A- 5 502 629**

## Description

The present invention relates to charge pump circuits, and more particularly to using triple well transistors in the design of charge pump circuits.

## BACKGROUND OF THE INVENTION

A charge pump is a circuit that can generate an output voltage that is higher than the voltage supplied to the charge pump. One of the applications of charge pumps is to develop voltage for erasing and programming some kinds of nonvolatile semiconductor memory devices, such as electrical erasable programmable read only memory (EEPROM) and flash memory. One way to operate these memory devices is to program through hot electron injection and erase through Fowler-Nordheim tunneling. The programming and erasing of such a memory cell require current to pass through the dielectric surrounding a floating gate electrode. As a result, a high voltage is generally needed. Some prior art nonvolatile semiconductor memory devices require the application of an external high voltage (e.g, 12 volts) in addition to a regular 5 volts supply voltage. This arrangement is undesirable because it is complicated and wastes real estate on circuit boards. Recently, many nonvolatile semiconductor memory device manufacturers place charge pumps on chip so as to develop the required high voltage for erasing and programming. Many customers welcome this development, and the sale of nonvolatile semiconductor devices increases.

US-A-5 489 870 discloses a voltage booster circuit. Charge transfer transistors are provided which cause charge to be transferred from one stage to the next in order to boost the voltage. Additional, separate, transistors are provided to reduce the susceptibility of the threshold voltage of the charge transfer transistors to the back bias effect.

As the number of memory cells in a nonvolatile semiconductor memory device increases, the current required to erase and program these cells also increases. As a result, there is a need for the charge pump to be efficient, e.g., generating more current and at a faster rate.

## SUMMARY OF THE INVENTION

According to one aspect of the present invention there is provided a charge pump comprising a semiconductor body having a particular conductivity type; a first well in said semiconductor body having said particular conductivity type; a second well in said semiconductor body surrounding said first well and having an opposite conductivity type relative to the particular conductivity type; a plurality of transistors, each of the transistors in the plurality having a source terminal and a drain terminal, the plurality of transistors arranged in series from a first transistor in the series coupled to a power supply voltage ($V_{DD}$; GND) to a last transistor in the plurality coupled to an output of the charge pump, to pump a voltage level of said output of the charge pump in response to one or more clock pulses, said last transistor having a voltage level substantially higher than, for a positive voltage output, or negative relative to, for a negative voltage output, said power supply voltage, the plurality of transistors in the series being connected such that, for a positive voltage output, the source of one of the transistors in the series is connected to the drain of a preceding transistor in the series, and, for a negative voltage output, the drain of one of the transistor in the series is connected to the source of a preceding transistor in the series; said source terminal and said drain terminal of at least said one of said plurality of transistors comprising respective regions of said opposite conductive type formed in said first well, said first well, said second well and said source region being connected together.

Embodiments of the present invention relate to using triple well transistors to increase the efficiency of a charge pump. The inventive charge pump comprises a plurality of pumping transistors arranged to increase the voltage level from a first pumping transistor to a last pumping transistor in response to clock pulses applied to these pumping transistors. At least one of the plurality of pumping transistors has a source and a drain region of a first conductive type formed on a first well having an opposite conductive type.

A second well having the first conductive type can be formed outside of the first well. The second well is fabricated on a substrate. This transistor design is commonly referred to as a "triple well" transistor. The source region, first well and the second well is preferably set to substantially the same potential. In one embodiment of the present invention, the second well can be set to the highest positive potential of the charge pump.

One aspect of this configuration is that the first well forms a semiconductor diode with the drain region. This diode allows more current to flow through the pumping transistor, when compared with a pumping transistor of conventional construction. Another aspect of this arrangement is that it reduces the body effect of the triple well transistor. As a result, the threshold voltage of the transistor is reduced. The reduction in threshold vohage allows the transistor to be turned on faster.

It is found that the above mentioned diode and threshold voltage reduction effects, singly and in combination, allow the charge pump to operate more efficiently. Example of the improved efficiency include increasing the output current, lowering the power supply voltage level, and increasing the operating frequency.

The triple well pumping transistor of embodiments of the present invention can be used in positive voltage and negative voltage charge pumps.

These and other features of the present invention will become apparent from the following detailed description of the invention read in conjunction with the accompanying drawings.

**BRIEF DESCRIPTION OF THE DRAWINGS**

Fig. 1 is a schematic diagram of a four-stage charge pump of an embodiment of the present invention.

Fig. 2 shows timing diagram of clock pulses that can be used with the charge pump of Fig. 1.

Fig. 3 shows, schematically, a cross sectional view of a triple well NMOS transistor of an embodiment of the present invention.

Fig. 4 is the top view of four triple well transistors of an embodiment of the present invention that can be used in the charge pump of Fig. 1.

Fig. 5 shows voltage profiles at various points of the charge pump of Fig. 1.

Fig. 6 is a schematic diagram of a negative voltage charge pump of an embodiment of the present invention.

**DETAILED DESCRIPTION OF EMBODIMENTS OF THE INVENTION**

Embodiments of the present invention relate to a novel charge pump system. The following description is presented to enable any person skilled in the art to make and use the invention. Descriptions of specific applications are provided only as examples. Various modifications to the preferred embodiments will be readily apparent to those skilled in the art, and the general principles defined herein may be applied to other embodiments and applications without departing from the scope of the invention. Thus, the present invention is not intended to be limited to the embodiments shown, but is to be accorded the widest scope consistent with the principles and features disclosed herein.

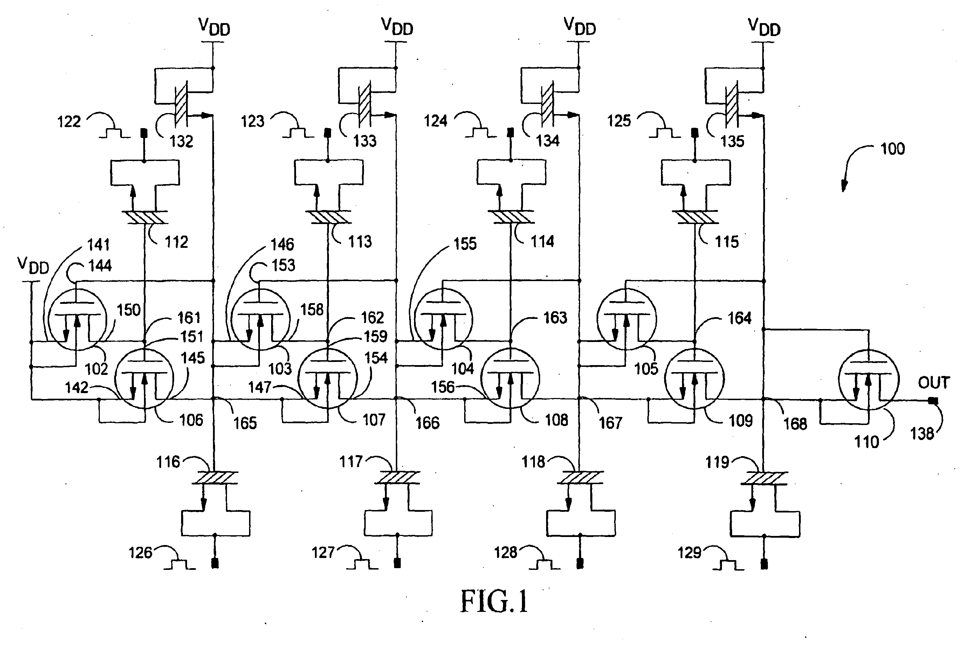

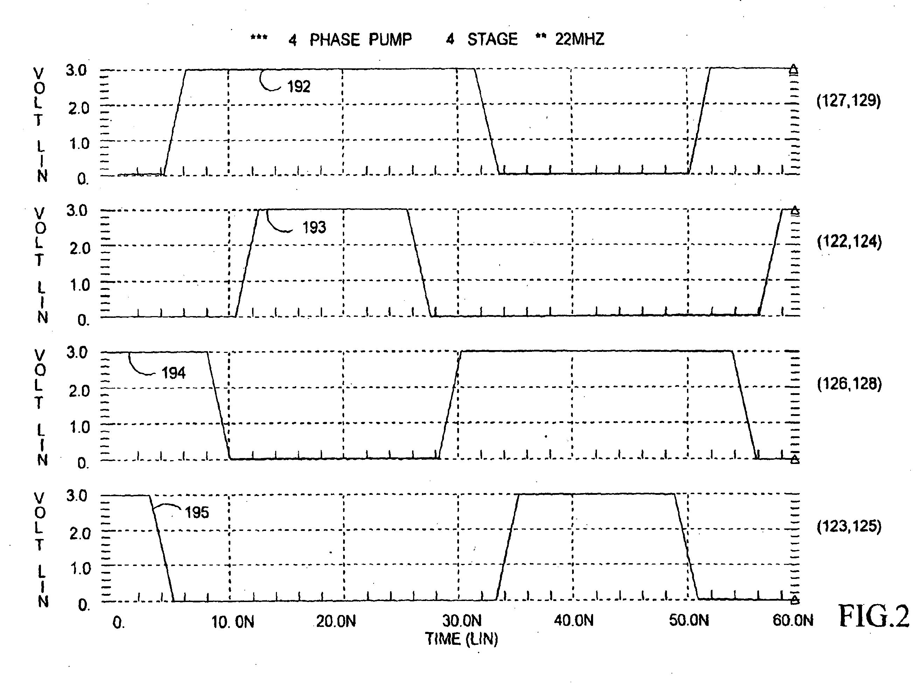

Fig. 1 is a schematic diagram of a four-stage charge pump 100 of an embodiment of the present invention. Charge pump 100 comprises nine triple well NMOS transistors 102-110 and twelve normal NMOS transistors 112-119 and 132-135. These normal NMOS transistors are preferably native n-channel devices that have a low threshold voltage. Normal NMOS transistors 132-135 function as pull up transistors. Normal NMOS transistors 112-119 function as capacitors, and are coupled to clock pulses 122-129. The clock pulses are coupled to the corresponding triple well NMOS transistors via the capacitive action of transistors 112-119. Although there are eight clock pulses, they are arranged in pairs: (122,124), (123,125), (126,128), and (127,129). Each clock pulse in a pair has the same pulse timing while different pairs have different pulse timings. The clock pulses are shown in Fig. 2 where timings 192-195 correspond to pairs (127,129), (122,125), (126, 128) and (123, 125), respectively. These pulses alternatively boost up the gates of these capacitors. This results in an increase in voltage level from stage to stage. The way voltage is being pumped up is similar to a conventional charge pump. In one embodiment of the present invention, the output voltage at the drain terminal of triple well NMOS 110 is approximately 10.5 volts while the voltage supplied to charge pump 100 is only 3 volts. As explained in detail below, the use of these triple well transistors (instead of normal NMOS transistors) enhances the performance and efficiency of charge pump 100 compared to prior art four-stage charge pumps.

It should be noted that a charge pump preferably includes other associated circuits, e.g., precharge and voltage regulation circuits. These circuits are well known by persons of ordinary skill in the art, and will not be described here.

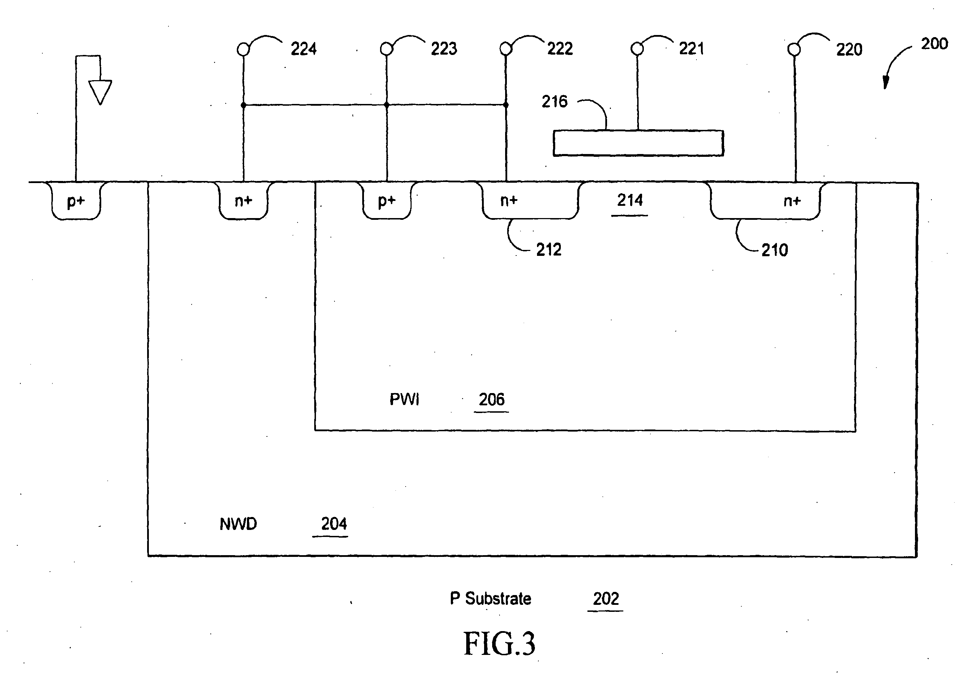

Fig. 3 shows, schematically, a cross sectional view of a triple well NMOS transistor 200 that can be used for transistors 102-110 of Fig. 1. Transistor 200 is fabricated on a p-type substrate 202. An N well 204 is formed in substrate 202, and a P well 206 is formed in N well 204. An N+ type drain region 210 is formed in P well 206, as is an N+ source region 212. A channel region 214 is defined between source and drain regions in P well 206. A polysilicon gate 216 is positioned above channel region 214. A thin gate oxide is deposited between gate 216 and channel region 214. Drain region 210, gate 216, source region 212, P well 206, and N well 204 are coupled to individual terminals 220-224, respectively. Thus, triple well transistor 200 can be considered a five-terminal device. In one embodiment of the present invention, the N+ source and N+ drain are interchangeable when the charge pump is activated because either terminal may have higher potential than the other.

In one embodiment of the present invention, the potential of source region 212, P well 206 and N well 204 are set to the same value. One way to meet this condition is to electrically connecting terminals 222, 223 and 224. The potential of substrate 202 is normally set to ground. This arrangement creates a PN diode between P well 206 and drain region 210. The diode is inherent in this triple well construction, and does not occupy any extra silicon area. This diode is able to conduct significant amount of current after it is turned on, and thus adds an extra low resistance path to the NMOS transistor. In this application, this diode is called an "extra diode." As explained in more detail below, this extra diode has the following advantageous effects:

(1) The size of the pass gate of the triple well NMOS transistors 102-109 can be reduced because some of the current for charging the next stage NMOS capacitors (i.e., transistors 112-119) can be conducted by the extra diode.

(2) Because the size of the NMOS transistors 102-109 can be reduced, their parasitic capacitance is reduced. As a result, less power is consumed and the pump output current can be increased.

(3) This low resistance extra diode path increases the forward conduction current. It can increase the pumping frequency because charges can be built up faster.

(4) The extra diode conduction path reduces the peak voltage swing at the output transistor 110 from $V_{DD}+V_{out}$ to $0.7+V_{out}$ volts, where $V_{DD}$ is the power supply voltage and $V_{out}$ is the output voltage at an output terminal 138 of charge pump 100. As a result, the internal voltage stress of the charge pump is reduced.

As a result of the above mentioned advantages, the performance of charge pump 100 improves tremendously by the presence of this diode. This benefit is achieved without requiring any silicon real estate.

Another advantage of this arrangement is that the body effect is suppressed. Body effect arises when the source and substrate is reverse biased. It is well known that the threshold voltage of a NMOS transistor is given by:

$$V_T = V_{T0} + \gamma \sqrt{[(V_{BS} + V_{BI})^2 - (V_{BI})^2]},$$

where $V_{T0}$ is the threshold voltage when there is no substrate bias, $V_{BS}$ is the potential between the source and the body, and $V_{BI}$ is the voltage difference of a P-N junction if no external voltage is applied (i.e., zero bias): The typical values for $V_{T0}$, $V_{BI}$ and $\gamma$ are 0.7 volt, 0.7 volt, and 0.4, respectively.

It can be seen from the above equation that applying a voltage across a reverse-biased source-substrate junction tends to increase the threshold voltage of a transistor. In the triple well transistor of the present invention, $V_{BS}$ is limited within the P-N junction cut-in voltage of 0.7 volt. This is because when pumping is activated, charge flows from N+ diffusion region 212 to N+ diffusion region 210 through channel 214 and the extra diode created by well 206 and region 210. Thus, the lower potential N+ diffusion region 210, which is the source, suffers minimized substrate bias around 0.7 volt which is much less as compared to more than 10 volts of substrate bias in prior art regulator NMOS charge pumps. In a charge pump circuit, it is important to generate high forward conduction current so that charges can be build up quickly. A low threshold voltage allows the NMOS channels to be turned on faster, and thus can increase the pumping frequency. Because the threshold voltage of the triple well NMOS transistor of the present invention is very low, the pumping frequency of the present inventive charge pump can be much higher than prior art charge pumps. In an embodiment of the present invention, the charge pump can operate efficiently at 22 MHz while prior art charge pump typically operates at 10 MHz.

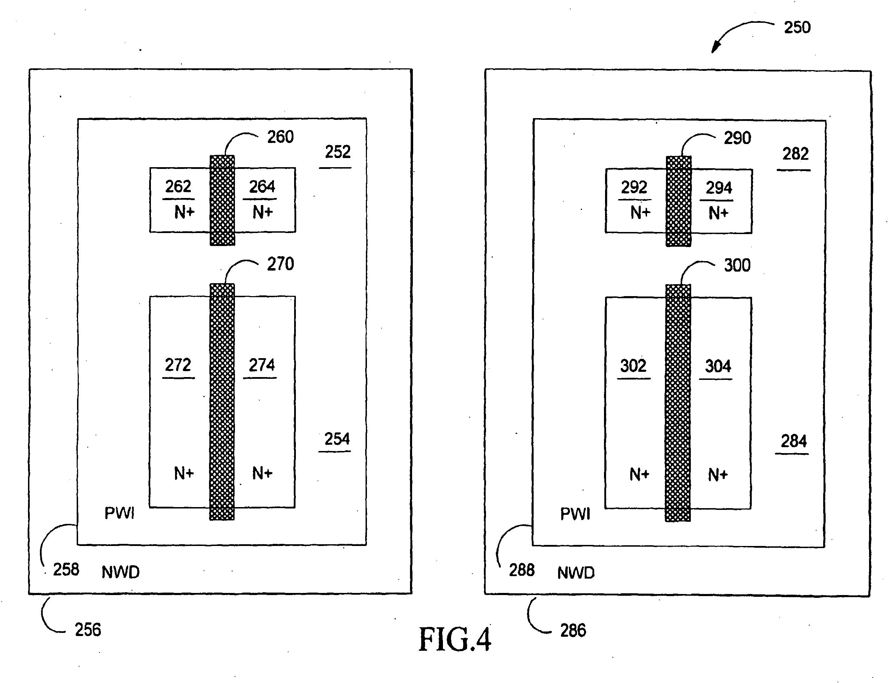

Fig. 4 shows a top view 250 of four triple well transistors used in the present invention. It shows two transistors 252 and 254 formed inside a P well 258 and an N well 256. Transistors 252 further comprises a gate 260, a source region 262 and a drain region 264. Transistor 252 could correspond to transistor 102 of Fig. 1. Transistor 254 further comprises a gate 270, a source region 272 and a drain region 274. Transistor 254 could correspond to transistor 106 of Fig. 1.

Fig. 4 also shows two transistor 282 and 284 formed inside a P well 288 and an N well 286. Transistor 282 further comprises a gate 290, a source region 292 and a drain region 294. Transistor 282 could correspond to transistor 103 of Fig. 1. Transistor 284 further comprises a gate 280, a source region 282 and a drain region 284. Transistor 284 could correspond to transistor 107 of Fig. 1.

Referring to both Figs. 1 and 4, the source terminal 141 of transistor 102 and source terminal 142 of transistor 106 are connected to $V_{DD}$. Thus, source regions 262 and 272 of transistors 252 and 254, respectively, have the same potential (i.e., $V_{DD}$). As explained above, P well 258 and N well 256 should have the same potential as source regions 262 and 272. Thus these two wells also have the same potential ($V_{DD}$).

Fig. 1 shows that the gate terminal 144 of transistor 102 is connected to the drain terminal 145 of transistor 106, the source terminal 146 of transistor 103 and the source terminal 147 of transistor 107. As explained above, P well 288 and N well 286 should have the same potential as source regions 292 and 302 (which are coupled to source terminals 146 and 147). Thus in Fig. 4, gate 260, drain region 274, source regions 292 and 302, N well 286 and P well 288 all have the same potential.

Fig. 1 shows that the drain terminal 150 of transistor 102 is connected to the gate 151 of transistor 106. Thus, in Fig. 4, drain region 264 has the same potential as gate 270.

Fig. 1 shows that the gate terminal 153 of transistor 103 is connected to the drain terminal 154 of transistor 107 (in addition to the source terminals 155 and 156 of transistors 104 and 108). Thus in Fig. 4, gate 290 has the same potential as drain region 304. Fig. 1 also shows that the drain terminal 158 of transistor 103 is connected to the gate 159 of transistor 107. Thus, in Fig. 4, drain region 294 has the same potential as gate 300.

In Fig. 4, only four of the nine triple well NMOS transistors comprising a charge pump are shown. The structure of transistors 104-105 and 108-109 is similar to that shown in Fig. 4. The structure of transistor 110 is similar to that of transistor 254 of Fig. 4.

In one embodiment of the present invention, the channel lengths of all the triple well transistors are 1.2 $\mu$m. The channel width of transistors 252 and 282 (corresponding to transistors 102 and 103 of Fig. 1) is 6 $\mu$m while the channel widths of transistors 254 and 284 (corresponding to transistors 106 and 107 of Fig. 1) are 18 $\mu$m. Transistors 104 and 105 have the same structure as transistors 102 and 103, respectively. Thus, these two transistors also have a channel length of 1.2 $\mu$m and a channel width of 6 $\mu$m. Transistors 108 and 109 have the same structure as transistors 106 and 107, respectively. Thus, these two transistors also have a channel length of 1.2 $\mu$m and a channel width of 18 $\mu$m. For the output transistor 110 of Fig. 1, the channel widths are 15 $\mu$m.

The dimension of normal transistors 112-119 and 132-135 of the same embodiment is shown in Table 1.

**TABLE 1**

| Transistor | Channel Length ($\mu$m) | Channel Width ($\mu$m) |
|---|---|---|
| 112 | 10 | 18 |
| 113 | 10 | 18 |
| 114 | 20 | 18 |
| 115 | 20 | 24 |
| 116 | 120 | 60 |
| 117 | 120 | 60 |
| 118 | 120 | 60 |
| 119 | 120 | 60 |
| 132 | 1.2 | 4 |
| 133 | 1.2 | 4 |
| 134 | 1.2 | 4 |
| 135 | 1.2 | 4 |

In order to determine the improvement of the triple well transistors over normal transistors in a charge pump, four tables showing the pump load lines are presented below. In each table, the two right hand columns correspond to the load line of a charge pump constructed using the preferred triple well transistor of the present invention. The two columns to the left of these two right hand columns correspond to the load line of the same charge pump constructed using normal transistors. It is observed that the inventive charge pump has a higher current at almost all voltage levels.

**TABLE 2: pump load line, $V_{DD}$=2v, temp=25 C**

| $I_{out}$ measure by root-mean-square, unit in mA | | | | |
|---|---|---|---|---|
| $V_{out}/I_{out}$ | Prior Art-4-Phase 7.3MHz | Prior Art-4-Phase 22 MHz | Preferred-4-Phase 7.3MHz | Preferred-4-Phase 22 MHz |
| 10v | 0.0 | 0.0 | 0.0 | 0.0 |
| 9v | 0.0 | 0.0 | 0.01 | 0.02 |
| 8v | 0.01 | 0.01 | 0.04 | 0.1 |
| 7v | 0.04 | 0.05 | 0.09 | 0.24 |
| 6v | 0.08 | 0.12 | 0.19 | 0.48 |

(continued)

| Iout measure by root-mean-square, unit in mA | | | | |
|---|---|---|---|---|
| Vout/Iout | Prior Art-4-Phase 7.3MHz | Prior Art-4-Phase 22 MHz | Preferred-4-Phase 7.3MHz | Preferred-4-Phase 22 MHz |
| 5v | 0.14 | 0.19 | 0.27 | 0.75 |

TABLE 3: pump load line, $V_{DD}$=2v, temp=25 C

| Iout measure by average, unit in mA | | | | |
|---|---|---|---|---|
| Vout/Iout | Prior Art-4-Phase 7.3MHz | Prior Art-4-Phase 22 MHz | Preferred-4-Phase 7.3MHz | Preferred-4-Phase 22 MHz |
| 10v | 0.0 | 0.0 | 0.0 | 0.0 |
| 9v | 0.0 | 0.0 | 0.01 | 0.02 |
| 8v | 0.01 | 0.01 | 0.03 | 0.9 |
| 7v | 0.04 | 0.05 | 0.06 | 0.17 |
| 6v | 0.06 | 0.11 | 0.08 | 0.25 |
| 5v | 0.09 | 0.166 | 0.10 | 0.31 |

TABLE 4: pump load line, $V_{DD}$=3v, temp=25 C

| Iout measure by Root-mean-square, unit in mA | | | | |
|---|---|---|---|---|
| Vout/Iout | Prior Art-4-Phase 7.3MHz | Prior Art-4-Phase 22 MHz | Preferred-4-Phase 7.3MHz | Preferred-4-Phase 22 MHz |
| 10v | 0.11 | 0.266 | 0.29 | 0.75 |
| 9v | 0.176 | 0.396 | 0.05 | 1.39 |
| 8v | 0.256 | 0.548 | 0.75 | 1.6 |
| 7v | 0.341 | 0.712 | 0.92 | 1.75 |
| 6v | 0.419 | 0.799 | 1.25 | 1.8 |
| 5v | 0.47 | 0.952 | 1.35 | 1.98 |

TABLE 5: pump load line, $V_{DD}$=3v, temp=25 C

| Iout measure by average, unit in mA | | | | |
|---|---|---|---|---|
| Vout/Iout | Prior Art-4-Phase 7.3MHz | Prior Art-4-Phase 22 MHz | Preferred-4-Phase 7.3MHz | Preferred-4-Phase 22 MHz |
| 10v | 0.078 | 0.217 | 0.107 | 0.302 |
| 9v | 0.108 | 0.300 | 0.128 | 0.423 |
| 8v | 0.137 | 0.386 | 0.157 | 0.460 |
| 7v | 0.167 | 0.468 | 0.178 | 0.496 |
| 6v | 0.190 | 0.520 | 0.205 | 0.504 |
| 5v | 0.203 | 0.597 | 0.222 | 0.532 |

The result shown in Tables 2-5 shows the following:

(1) The charge pump of the present invention functions efficiently at low $V_{DD}$ voltage. For example, the performance improvement of the inventive charge pump over prior art charge pumps at $V_{DD}$ = 2 volts is greater than that at $V_{DD}$ = 3 volts. It is found that the inventive charge pump can operate effectively down to 1.5 volt.

(2) The charge pump of the present invention can operate efficiently at 22 MHz. For example, Table 2 shows that the output current for the inventive charge pump at 22 MHz is about 2.5 times that at 7.3 MHz ($V_{out}$ = 7 v). On the other hand, there is little difference in the output current of a prior art charge pump at 22 MHz and 7.3 MHz.

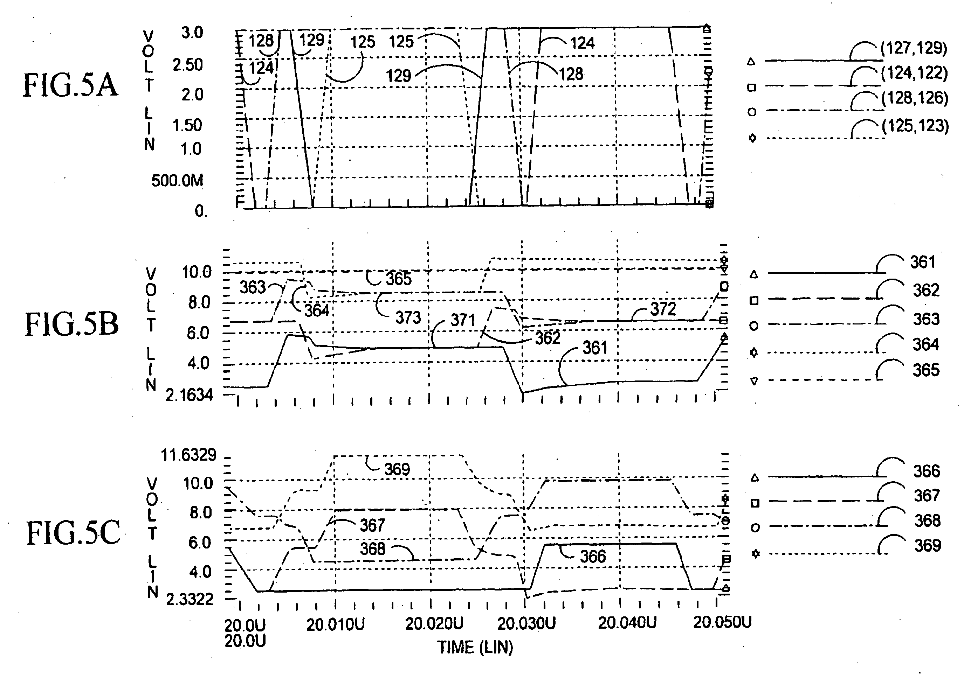

The operation of charge pump 100 is now explained. Fig. 5A-5C show voltage profiles at nodes 161-168 and 138 of Fig. 1. Fig. 5A shows four clock pulses which are the same as pulses 124, 125, 128 and 129 of Fig. 2. These clock pulses are shown here again so as to provide a reference to understand the voltage profiles. Fig. 5B shows the voltage profiles 361-365 at nodes 165-168 and 138, respectively. Fig. 5C shows the voltage profiles 366-369 at nodes 161-164, respectively. It can be seen at regions 371-373 of Fig. 5B that charges are being pumped to subsequent stages when the triple well transistors 107-109 are turned on. As a result, the voltages of the two adjoining stages are equal at these regions. This pumping effect is enhanced by the extra diode and reduced threshold voltage of the corresponding triple well transistor of the present invention. The improved effect of other triple well transistors can be easily analyzed by person skilled in the art, and will be not explained in detail here.

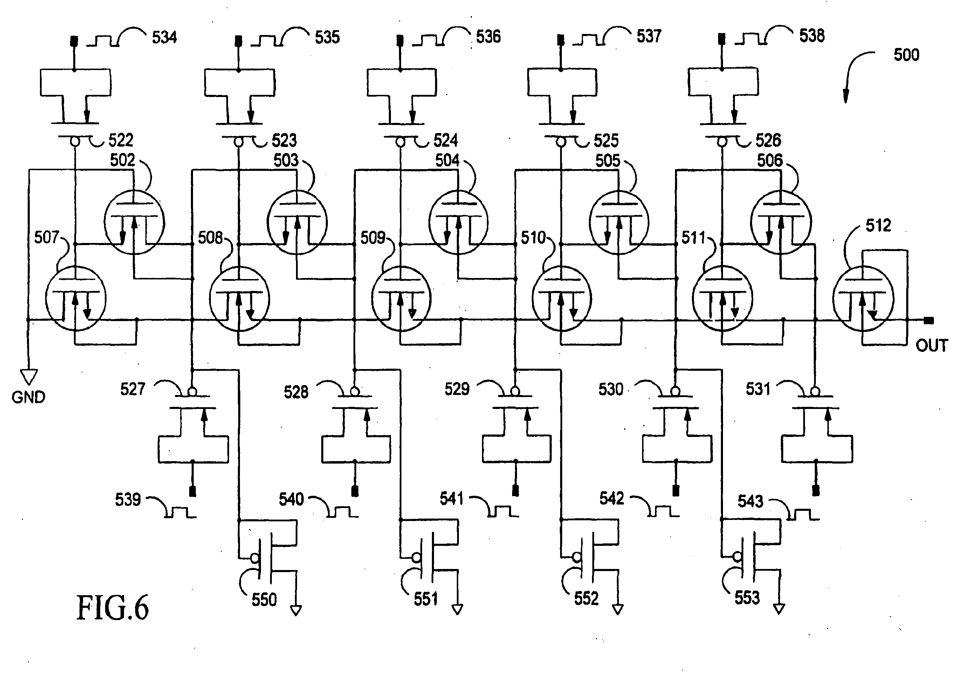

The present invention can be applied to a negative charge pump having a negative output voltage. Fig. 6 is a schematic diagram of a negative charge pump 500 in accordance with the present invention. Charge pump 500 comprises eleven triple well NMOS transistors 502-512 and ten P-channel transistors 522-531. These P-channel transistors function as capacitors, and are coupled to clock pulses 534-543. The clock pulses are coupled to the corresponding triple well NMOS transistors via the capacitive action of transistors 522-531. Four P-channel transistors 550-553 can be optionally connected to the drain terminals of triple well transistors 508-511 for initial pull-down purpose. In one embodiment of the present invention, the output voltage at the source terminal of triple well NMOS 512 is approximately -8 volts when the voltage supplied to charge pump 500 is approximately 3 volts. The use of a triple well structure in transistors 502-512 suppresses the body effect and introduces an extra diode in the same way as discussed above in connection with charge pump 100. Thus, all the beneficial effects described above is also present in charge pump 500.

While several embodiments have been disclosed, it will be readily apparent to those skilled in the art that numerous other modifications and variations not mentioned above can still be made without departing from the scope of the invention claimed below. For example, the above disclosed triple well structure is not limited to be used in the charge pump design of Figs. 1 and 6, but instead can be used in practically all charge pump circuits.

## Claims

1.   A charge pump comprising:

   a semiconductor body (202) having a particular conductivity type;
   a first well (206) in said semiconductor body having said particular conductivity type;
   a second well (204) in said semiconductor body surrounding said first well and having an opposite conductivity type relative to the particular conductivity type;
   a plurality of transistors (106-110; 507-512), each of the transistors in the plurality having a source terminal and a drain terminal, the plurality of transistors arranged in series from a first transistor in the series coupled to a power supply voltage ($V_{DD}$; GND) to a last transistor (110; 512) in the plurality coupled to an output of the charge pump, to pump a voltage level of said output of the charge pump in response to one or more clock pulses, said last transistor having a voltage level substantially higher than, for a positive voltage output, or negative relative to, for a negative voltage output, said power supply voltage, the plurality of transistors in the series being connected such that, for a positive voltage output, the source of one of the transistors in the series is connected to the drain of a preceding transistor in the series, and, for a negative voltage output, the drain of one of the transistor in the series is connected to the source of a preceding transistor in the series;

   **characterized in that**
   said source terminal and said drain terminal of at least said one of said plurality of transistors comprising respective regions of said opposite conductive type formed in said first well, said first well, said second well and said source region being connected together.

2.   The charge pump of claim 1 wherein said power supply voltage is in a range between approximately 5 and approximately 1.5 volts.

3. The charge pump of claim 1 wherein said power supply voltage is substantially equal to 3 volts.

4. The charge pump of claim 1 wherein said power supply voltage is substantially equal to 2 volts.

5. The charge pump of claim 1 wherein at least one of said clock pulses operates at a frequency above 10 MHz.

6. The charge pump of claim 1 wherein at least one of said clock pulses operates at a frequency approximately equal to 22 MHz.

7. The charge pump of claim 1 wherein said voltage level at said last transistor is positive.

8. The charge pump of claim 1 wherein said voltage level at said last transistor is negative.

9. The charge pump of claim 1 further comprising means for coupling said clock pulses to said transistors.

10. The charge pump of claim 12 wherein said means for coupling comprises a MOS transistor.

11. The charge pump of claim 1, wherein said plurality of transistors comprise a plurality of charge pump stages arranged in series to pump said voltage level from a first stage to a last stage in response to said one or more clock pulses; and wherein
at least one of the charge pump stages comprises a first transistor having a gate, a source and a drain and a second transistor having a gate coupled to the drain of the first transistor, a source coupled to the source of the first transistor, and a drain coupled to the gate of the first transistor, and wherein the respective drains and sources of the first and second transistors are within the first well, and the sources of the first and second transistors are coupled to the first well.

12. The charge pump of claim 11, wherein the first well and the second well are coupled together to the sources of the first and second transistors.

13. The charge pump of claim 1, wherein said plurality of transistors comprise a plurality of charge pump stages arranged in series to pump said voltage level from a first stage to a last stage in response to said one or more clock pulses; and wherein
the respective charge pump stage in the plurality comprises a first well in said semiconductor body having said particular conductivity type; a second well in said semiconductor body surrounding said first well and having an opposite conductivity type relative to the particular conductivity type; a first transistor having a gate, a source and a drain and a second transistor having a gate coupled to the drain of the first transistor, a source coupled to the source of the first transistor, and a drain coupled to the gate of the first transistor, and wherein the respective drains and sources of the first and second transistors are within the first well, and the sources of the first and second transistors are coupled to the first well.

**Patentansprüche**

1. Ladungspumpe, welche folgendes beinhaltet:

einen Halbleiterkörper (202) mit einem bestimmten Leitfähigkeitstyp,
einen ersten Well (206) in dem Halbleiterkörper mit dem bestimmten Leitfähigkeitstyp,
einen zweiten Well (204) in dem Halbleiterkörper, welcher den ersten Well umgibt und einen in Bezug auf den bestimmten Leitfähigkeitstyp entgegengesetzten Leitfähigkeitstyp aufweist,
eine Mehrzahl von Transistoren (106-110; 507-512), wobei jeder der Transistoren in der Mehrzahl einen Sourceanschluß und einen Drainanschluß aufweist, wobei die Mehrzahl von Transistoren ausgehend von einem ersten Transistor in der Reihe, der an eine Stromversorgungsspannung ($V_{DD}$; GND) angeschlossen ist, zu einem letzten Transistor (110; 512) in der Mehrzahl, der an einen Ausgangsanschluß der Ladungspumpe angeschlossen ist, in Reihe angeordnet ist, um ein Spannungsniveau des Ausgangsanschlusses der Ladungspumpe in Reaktion auf einen oder mehrere Taktimpulse zu pumpen, wobei der letzte Transistor ein Spannungsniveau hat, welches bei einem positiven Spannungsausgang wesentlich höher ist bzw. bei einem negativen Spannungsausgang stärker negativ ist als die Stromversorgungsspannung, wobei die Mehrzahl von Transistoren in der Reihe so miteinander verbunden ist, daß bei einem positiven Spannungsausgang die Source eines der Transistoren in der Reihe mit der Drain eines vorangegangenen Transistors in der Reihe verbunden ist, und bei einem negativen Spannungsausgang die Drain eines der Transistoren in der Reihe mit der Source eines vorangegangenen Transistors in der Reihe verbunden ist, **dadurch gekennzeichnet, daß** der Sourceanschluß und der Drainanschluß von wenigstens einem aus der Mehrzahl von Transistoren entsprechende Bereiche desjenigen Leitfähigkeitstyps aufweise, der dem in dem ersten Well ausgebildeten Leitfähigkeitstyp entgegengesetzt ist, wobei der erste Well, der zweite Well und die Sourceregion miteinander verbunden sind.

2. Ladungspumpe nach Anspruch 1, wobei die Stromversorgungsspannung in einem Bereich zwischen ungefähr 5 und ungefähr 1,5 Volt liegt.

3. Ladungspumpe nach Anspruch 1, wobei die Stromversorgungsspannung im wesentlichen gleich 3 Volt ist.

4. Ladungspumpe nach Anspruch 1, wobei die Stromversorgungsspannung im wesentlichen gleich 2 Volt ist.

5. Ladungspumpe nach Anspruch 1, wobei wenigstens einer der Taktimpulse bei einer Frequenz oberhalb von 10 MHz arbeitet.

6. Ladungspumpe nach Anspruch 1, wobei wenigstens einer der Taktimpulse bei einer Frequenz von ungefähr gleich 22 MHz arbeitet.

7. Ladungspumpe nach Anspruch 1, wobei das Spannungsniveau an dem letzten Transistor positiv ist.

8. Ladungspumpe nach Anspruch 1, wobei das Spannungsniveau an dem letzten Transistor negativ ist.

9. Ladungspumpe nach Anspruch 1, welche weiterhin Einrichtungen zum Koppeln der Taktimpulse an die Transistoren beinhaltet.

10. Ladungspumpe nach Anspruch 12, wobei die Einrichtungen zum Koppeln einen MOS-Transistor beinhalten.

11. Ladungspumpe nach Anspruch 1, wobei die Mehrzahl von Transistoren eine Mehrzahl von in Reihe angeordneten Ladungspumpenstufen beinhaltet, um das Spannungsniveau in Reaktion auf den einen oder die mehreren Taktimpulse von einer ersten Stufe zu einer letzten Stufe zu pumpen, und wobei wenigstens eine der Ladungspumpenstufen einen ersten Transistor mit einem Gate, einer Source und einer Drain und einen zweiten Transistor mit einem Gate, welches mit der Drain des ersten Transistors verbunden ist, einer Source, die mit der Source des ersten Transistors verbunden ist, und einer Drain, die mit dem Gate des ersten Transistors verbunden ist, beinhaltet, und wobei die jeweiligen Drains und Sources des ersten und des zweiten Transistors innerhalb des ersten Wells liegen und die Sources des ersten und des zweiten Transistors mit dem ersten Well verbunden sind.

12. Ladungspumpe nach Anspruch 11, wobei der erste Well und der zweite Well zusammen mit den Sources des ersten und des zweiten Transistors verbunden sind.

13. Ladungspumpe nach Anspruch 1, wobei die Mehrzahl von Transistoren eine Mehrzahl von in Reihe angeordneten Ladungspumpenstufen aufweisen, um das Spannungsniveau in Reaktion auf den einen oder die mehreren Taktimpulse von einer ersten Stufe zu einer letzten Stufe zu pumpen, und wobei die jeweilige Ladungspumpenstufe in der Mehrzahl einen ersten Well in dem Halbleiterkörper mit dem bestimmten Leitfähigkeitstyp, einen zweiten Weil in dem Halbleiterkörper, welcher den ersten Weil umgibt und einen in Bezug auf den bestimmten Leitfähigkeitstyp entgegengesetzten Leitfähigkeitstyp aufweist, einen ersten Transistor mit einem Gate, einer Source und einer Drain und einen zweiten Transistor mit einem Gate, welches mit der Drain des ersten Transistors verbunden ist, einer Source, die mit der Source des ersten Transistors verbunden ist, und einer Drain, die mit dem Gate des ersten Transistors verbunden ist, beinhaltet, und wobei die jeweiligen Drains und Sources des ersten und des zweiten Transistors innerhalb des ersten Wells liegen und die Sources des ersten und des zweiten Transistors mit dem ersten Well verbunden sind.

**Revendications**

1.  Pompe à charge comprenant :

    un corps semiconducteur (202) ayant un type de conductivité particulier,
    un premier puits (206) dans ledit corps semiconducteur ayant ledit type de conductivité particulier,
    un deuxième puits (204) dans ledit corps semiconducteur entourant ledit premier puits et ayant un type de conductivité opposé par rapport au type de conductivité particulier,
    une pluralité de transistors (106 à 110 ; 507 à 512), chacun des transistors dans la pluralité ayant une borne de source et une borne de drain, la pluralité de transistors étant disposés en série d'un premier transistor dans la série relié à une tension d'alimentation ($V_{DD}$ ; GND) à un dernier transistor (110 ; 512) dans la pluralité relié à une sortie de la pompe à charge, pour pomper un niveau de tension de ladite sortie de la pompe à charge en réponse à une ou plusieurs impulsions d'horloge, ledit dernier transistor présentant un niveau de tension sensiblement supérieur à ladite tension d'alimentation pour une sortie de tension positive, ou négative par rapport à celle-ci, pour une sortie de tension négative, la pluralité de transistors dans la série étant connectés de sorte que, pour une sortie de tension positive, la source de l'un des transistors dans la série est connectée au drain d'un transistor précédent dans la série, et pour une sortie de tension négative, le drain de l'un des transistors dans la série est connecté à la source d'un transistor précédent dans la série,

    **caractérisée en ce que**
    ladite borne de source et ladite borne de drain dudit au moins un transistor de ladite pluralité de transistors comprennent des régions respectives dudit type de conduction opposé formées dans ledit premier puits, ledit premier puits, ledit deuxième puits et ladite région de source étant connectés ensemble.

2.  Pompe à charge selon la revendication 1, dans laquelle ladite tension d'alimentation se trouve dans une plage entre approximativement 5 et approximativement 1,5 volts.

3.  Pompe à charge selon la revendication 1, dans laquelle ladite tension d'alimentation est sensiblement égale à 3 volts.

4.  Pompe à charge selon la revendication 1, dans laquelle ladite tension d'alimentation est sensiblement égale à 2 volts.

5.  Pompe à charge selon la revendication 1, dans laquelle au moins l'une desdites impulsions d'horloge agit à une fréquence au-dessus de 10 MHz.

6.  Pompe à charge selon la revendication 1, dans laquelle au moins l'une desdites impulsions d'horloge agit à une fréquence approximativement égale à 22 MHz.

7.  Pompe à charge selon la revendication 1, dans laquelle ledit niveau de tension au niveau dudit dernier transistor est positif.

8.  Pompe à charge selon la revendication 1, dans laquelle ledit niveau de tension au niveau dudit dernier transistor est négatif.

9.  Pompe à charge selon la revendication 1, comprenant en outre un moyen destiné à coupler lesdites impulsions d'horloge auxdits transistors.

10. Pompe à charge selon la revendication 12, dans laquelle ledit moyen de couplage comprend un transistor MOS.

11. Pompe à charge selon la revendication 1, dans laquelle ladite pluralité de transistors comprend une pluralité d'étages de pompe à charge disposés en série pour pomper ledit niveau de tension d'un premier étage à un dernier étage en réponse à ladite une ou plusieurs impulsions d'horloge, et dans laquelle
    au moins l'un des étages de la pompe à charge comprend un premier transistor comportant une grille, une source et un drain et un deuxième transistor ayant une grille couplée au drain du premier transistor, une source couplée à la source du premier transistor et un drain couplé à la grille du premier transistor, et dans laquelle les drains et les sources respectifs des premier et deuxième transistors se trouvent dans le premier puits, et les sources des premier et deuxième transistors sont couplées au premier puits.

12. Pompe à charge selon la revendication 11, dans laquelle le premier puits et le deuxième puits sont couplés ensemble aux sources des premier et deuxième transistors.

13. Pompe à charge selon la revendication 1, dans laquelle ladite pluralité de transistors comprend une pluralité d'étages de pompe à charge disposés en série pour pomper ledit niveau de tension d'un premier étage à un dernier étage en réponse auxdites une ou plusieurs impulsions d'horloge, et dans laquelle l'étage de pompe à charge respectif dans la pluralité comprend un premier puits dans ledit corps semiconducteur ayant ledit type de conductivité particulier, un deuxième puits dans ledit corps semiconducteur entourant ledit premier puits et ayant un type de conductivité opposé par rapport au type de conductivité particulier, un premier transistor comportant une grille, une source et un drain et un deuxième transistor ayant une grille couplée au drain du premier transistor, une source couplée à la source du premier transistor, et un drain couplé à la grille du premier transistor, et dans laquelle les drains et les sources respectifs des premier et deuxième transistors se trouvent dans le premier puits, et les sources des premier et deuxième transistors sont couplées au premier puits.

FIG.1

\*\*\* 4 PHASE PUMP 4 STAGE \*\* 22MHZ

FIG.2

EP 0 931 379 B1

FIG.3

200

220

221

222

223

224

210

212

214

216

206

204

202

n+

n+

p+

n+

p+

PWI

NWD

P Substrate

EP 0 931 379 B1

250

260
252
262 N+ | 264 N+
270
272 | 274
254
N+ | N+
PWI
258 NWD
256

290
282
292 N+ | 294 N+
300
302 | 304
284
N+ | N+
PWI
288 NWD
286

FIG.4

FIG.5A

FIG.5B

FIG.5C

EP 0 931 379 B1

FIG.6

EP 0 931 379 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5489870 A